# EUROPÄISCHE PATENTSCHRIFT

(11) **EP 1 821 405 B1**
(45) Veröffentlichungstag und Bekanntmachung des Hinweises auf die Patenterteilung: **30.12.2009**
(21) Anmeldenummer: 07002790.9
(22) Anmeldetag: 09.02.2007
(51) Int. Cl.: H03G 11/02

(54) **Verfahren zur Spannungsbegrenzung bei einem Transponder**
Method for voltage limitation for a transponder
Procédé destiné à limiter la tension dans un transpondeur

(30) Priorität: 15.02.2006 DE 102006006912
(43) Veröffentlichungstag der Anmeldung: 22.08.2007
(60) Teilanmeldung: 09009622.3
(73) Patentinhaber: Atmel Automotive GmbH, 74072 Heilbronn (DE)
(72) Erfinder: Berhorst, Martin, 69123 Heidelberg (DE); Kurz, Alexander, 74523 Schwäbisch Hall (DE); Schneider, Peter, 74855 Hassmersheim (DE)
(74) Vertreter: Müller, Wolf-Christian

(56) Entgegenhaltungen:
- EP-A- 1 589 656
- RAO YU ET AL: "Circuitry for a wireless microsystem for neural recording microprobes" PROCEEDINGS OF THE 23RD. ANNUAL INTERNATIONAL CONFERENCE OF THE IEEE ENGINEERING IN MEDICINE AND BIOLOGY SOCIETY. 2001 CONFERENCE PROCEEDINGS. (EMBS). INSTANBUL, TURKEY, OCT. 25 - 28, 2001, ANNUAL INTERNATIONAL CONFERENCE OF THE IEEE ENGINEERING IN M, Bd. VOL. 1 OF 4. CONF. 23, 25. Oktober 2001 (2001-10-25), Seiten 761-764, XP010593486 ISBN: 0-7803-7211-5

## Beschreibung

Die Erfindung betrifft ein Verfahren zur Spannungsbegrenzung gemäß dem Oberbegriff des Patentanspruchs 1. Darüber hinaus betrifft die Erfindung eine Schaltung zur Spannungsbegrenzung bei einem Transponder gemäß dem Oberbegriff des Patentanspruchs 6.

Ein solches Verfahren und eine solche Schaltung sind per se insbesondere durch RFID-Anwendungen (RFID = Radio Frequency Identification) bekannt. Unter einer RFID-Anwendung wird hier jede Anwendung verstanden, bei der ein Sendeschwingkreis einen induktiv gekoppelten Empfangsschwingkreis mit Energie versorgt und über den Empfangsschwingkreis Daten ausliest. Solche Verbindungen werden zum Beispiel zur Objektidentifikation verwendet, wobei ein Sendeschwingkreis eines Lesegerätes (reader) über einen Empfangsschwingkreis ein mit einer Marke (tag) ausgezeichnetes Objekt anspricht und Informationen abruft.

Für die Kontaktaufnahme erzeugt der Sendeschwingkreis des Lesegeräts ein hochfrequentes Magnetfeld, das in einer Induktivität eines Empfangsschwingkreises, der sich in der Nähe des Lesegerätes befindet, eine Wechselspannung induziert. Die in dem Empfangsschwingkreis induzierte Wechselspannung wird gleichgerichtet und dient zum Beispiel zur Energieversorgung einer an den Empfangsschwingkreis angeschlossenen integrierten Schaltung. Darüber hinaus lässt sich auch aus der induzierten Wechselspannung eine Taktfrequenz ableiten, die der integrierten Schaltung, also zum Beispiel einem Mikroprozessor und/oder einem Speicherelement als Systemtakt zur Verfügung gestellt werde kann. Durch die Ergänzung der Induktivität des Sendeschwingkreises und/oder Empfangsschwingkreises mit Kapazitäten, insbesondere mit parallel liegenden Kapazitäten, zu Schwingkreisen werden Resonanzeffekte erzielt, die den Wirkungsgrad der Energieübertragung erheblich verbessern.

Eine Übertragung von Daten vom Lesegerät zum Empfangsschwingkreis (downlink) kann zum Beispiel durch Einschalten und Ausschalten des Magnetfeldes erfolgen. Für einen Datentransport in umgekehrte Richtung vom Empfangsschwingkreis zum Lesegerät wird die so genannte Lastmodulation verwendet, die eine hinreichende Nähe (Abstand kleiner 0,16 * Wellenlänge) von Sende- und Empfangsschwingkreis erfordert. Bei hinreichender Nähe kommt es zur transformatorischen Kopplung, bei der sich die Energieaufnahme der Empfangsspule durch eine Rückwirkung auf den Sendeschwingkreis in Spannungsänderungen am Sendeschwingkreis abbildet. Gesteuerte Modulationen der Last, also der Impedanz des Empfangsschwingkreises, rufen daher Spannungsänderungen im Sendeschwingkreis hervor, die für eine Datenübertragung auswertbar sind.

Mit zunehmender Güte der im Empfangsschwingkreis verwendeten Induktivitäten, also mit zunehmendem Verhältnis von Blindwiderstand zu Wirkwiderstand verringern sich die Dämpfung des Schwingkreises und die Breite der Resonanzkurve. Die Verwendung von Spulen höhere Güte bewirkt also eine höhere Frequenzselektivität und, bei gleicher Spannung auf der reader-Seite, eine höhere Spannung auf der tag-Seite, was die Reichweite der Kommunikationsverbindung vergrößert. Bei kleinen Abständen zwischen Reader und Tag können je nach Sendeleistung im Tag derart große Spannungen induziert werden, dass eine im Tag vorhandene integrierte Schaltung zerstört werden kann.

Aus der DE 10 2004 020 816 A1 ist es bekannt, die Spannung am Empfangsschwingkreis auf bestimmte Werte zu reduzieren oder zu begrenzen, welche im Folgenden als erste Klemmspannung bezeichnet wird. Ferner wird im Rahmen der Lastmodulation zwischen einer ersten Spannung d.h. ersten Klemmspannung und einer zweiten niedrigeren Spannung umgeschaltet. Hierzu werden Sperrschichtbauelemente zwischen Schwingkreisanschlüssen und ein Bezugs- oder Massepotential geschaltet. Eine untere Klemmspannung wird zum Beispiel dadurch realisiert, dass über den Sperrschichtbauelementen deren Durchlassspannung abfällt, wobei der Spannungsabfall wegen der exponentiellen Abhängigkeit des Stroms von der Spannung in erster Näherung stromunabhängig ist.

Als Folge wirken die Sperrschichtbauelemente auch bei hohen Spulenströmen wie eine zuverlässige Begrenzung der Schwingkreisspannung auf einen zugehörigen Wert. Dies ist insbesondere bei Systemen mit Induktivitäten hoher Güte von Bedeutung, die bei räumlicher Nähe von Sendeschwingkreis und Empfangsschwingkreis sonst unerwünscht hohe Spannungen verursachen können.

Die obere Klemmspannung kann durch eine in Reihe mit umgekehrter Durchlassrichtung geschaltete Zenerdiode realisiert sein, die gesteuert oder geschaltet kurzzuschließen ist. Im kurzgeschlossenen Zustand erfolgt die beschriebene Begrenzung auf die untere Klemmspannung, während im nicht kurzgeschlossenen Zustand die Durchbruchspannung der Zenerdiode für eine additiven Spannungsversatz sorgt, der in der Summe mit den genannten Durchlassspannungen eine obere Klemmspannung definiert. Im Zustand mit kurzgeschlossener Zenerdiode fließt ein vergleichsweise großer Strom aus dem Empfangsschwingkreis heraus, was dem belasteten Zustand des Schwingkreises entspricht. Entsprechend wird die Stromentnahme aus dem Schwingkreis sowie die Belastung des Schwingkreises durch Öffnen des Kurzschlusses über der Zenerdiode verringert.

Bei der Lastmodulation aus der DE 10 2004 020 816 A1 ist das folgende Problem beobachtet worden: Wenn beim Einschalten der Modulation, also beim Begrenzen der Schwingkreisspannung auf die untere Klemmspannung, gerade ein hoher Spulenstrom induziert wird, so fließt dieser unter Umständen über die Überbrückung der Zenerdiode und die in Durchlassrichtung geschalteten übrigen Sperrschichtbauteile ab, wobei die Schwingkreisspannung unter die untere Klemmspannung und auch unter einen Schwellenwert fallen kann, der zur Detektion von Schwingungen (Pulsen) der Schwingkreisspannung dient. Es kann also bei ungünstigen Phasenbedingungen beim Einschalten der Last vorkommen, dass die Spannung am Sendeschwingkreis aufgrund der Rückwirkung für eine oder mehrere Perioden unter eine Detektionsschwelle sinkt, was die informationsübertragung verfälscht. Dadurch kann es zu einem Datenverlust bei der Informationsübertragung zum Lesegerät kommen.

Wird nämlich bei einem hohen induzierten Spulensrom die Modulation eingeschaltet, so sorgen die Sperrschichtbautelle für eine Begrenzung der Schwingkreisspannung auf einen durch die Sperrschichtbauteile vorbestimmten Wert. Die Dioden wirken in dieser Phase wie eine Gleichspannungsquelle und setzen somit dem Spulenstrom keine ausreichende Dämpfung entgegen, so dass die induzierte Schwingung verändert wird. Die Folge ist eine Verbrelterung der gerade anliegenden Taktphase (Pulsverbreiterung), die zumindest zur teilweisen Auslöschung der Folgeschwingung führt. Sie tritt dadurch in Erscheinung, dass mindestens eine Schwingung in der Amplitude zu klein für eine vorgegebene Detektionsschwelleist.

In dem Konferenzbericht "Circuitry for a wireless micorsystem for neural recording microprobes" veröffentllicht in Annual International Conference of The IEEE Engineering in M, Bd. Vol. 1 of 4. Conf. 23, 25. Oktober 2001 Seiten 761- 764 XP010593486, ist eine Spannungsbegrenzerschaltung für ein induktiv gekoppeltes System offenbart, die bei hohen induzierten Spannungen die angeschlossenen Schaltung vor Zerstörung schützt. Nachteilig ist, dass die Schaltung erst für ein gleichgerichtetes Signal einsetzbar ist.

Vor diesem Hintergrund besteht die Aufgabe der Erfindung in der Angabe eines Verfahrens und einer Schaltungsanordnungzur Spannungsbegrenzung in einem Transponder, das die Nachteile des Standes der Technik verringert.

Diese Aufgabe wird bei einem Verfahren der eingangs genannten Art dadurch gelöst, dass zur Spannungsbegrenzung bei einem Transponder mit einem ersten Sende- und Empfangsschwingkreis, der einen ersten Schwingkreisanschluss und einen zweiten Schwingkreisanschluss aufweist , ein steuerbares Sperrschlchtbauelement, mit einem Eingang, einen Ausgang und einem Steuereingang vorgesehen ist, und der Eingang mit dem ersten Schwingkreisanschluss verschaltet ist, der Ausgang mit dem zweiten Schwingkreisanschluss verschaltet, und von der Basisstation im Sende- und Empfangschwingkreis zwischen dem ersten und zweiten Schwingkreisanschluss eine Wechselspannung induziert wird, so dass die im Sende- und Empfangsschwingkreis induzierte Wechselspannung auf einen ersten Spannungswert begrenzt wird, indem bei jeder Halbwelle der induzierten Wechselspannung durch einen Zweig einer Polaritätswechselschaltung der Steuereingang des steuerbaren Sperrschichtbauelementes angesteuert wird.

Dieses Verfahren bietet den Vorteil, dass für beide Spannungshalbwellen insgesamt nur ein Sperrschichtbauteil vorgesehen werden muss, während bei bekannten Verfahren ein symmetrischer Aufbau von mindestens einem Sperrschichtbauteil für je eine Spannungshalbwelle vorgesehen war.

Vorteilhaft bei dem erfindungsgemäßen Verfahren Ist weiterhin, dass die Begrenzung der Spannung von einem ersten auf einen zweiten Spannungswert zur Lastmodulation erfolgt.

Als besonders vorteilhaft hat sich erwiesen, dass die Spannungsbegrenzung und die Lastmodulation mittels Ansteuerung desselben Sperrschichtbauelements erfolgt. Hierdurch wird das Verfahren wesentlich vereinfacht.

Eine weitere Ausgestaltung des Verfahrens sieht vor, dass die Änderung von der ersten auf eine zweite Spannung in wenigstens zwei Stufen erfolgt, indem wenigstens zwei Sperrschichtbauelemente zur Senkung der Spannung auf den zweiten, niedrigen Wert kaskadierend also nacheinander überbrückt werden. Dadurch wird der Spulenstrom, der bei Einschalten des Modulationstransistors schlagartig geflossen wäre, über mehrere Schwingungen verteilt. Dabei reduziert sich die Spulenspannung ebenfalls auf das Niveau der zweiten Spannung über mehrere Schwingungen.

Gemäß einem alternativen Verfahren erfolgt die Änderung von der ersten auf eine zweite Spannung linear, indem diese durch ein inverses Signal geregelt wird.

Des Weiteren wird die Aufgabe durch eine Schaltung zur Spannungsbegrenzung bei einem Transponder gelöst, der einen Schwingkreis, wenigstens eine Induktivität, eine Kapazität ein Sperrschichtbauteil mit einem Eingang, Ausgang und einem Steuereingang, sowie einen ersten Schwingkreisanschluss, der mit dem Eingang des Sperrschichtbauelements und einen zweiten Schwingkreisanschluss, der mit dem Ausgang des Sperrschichtbauelements verbunden ist, umfasst, wobei eine Verbindung des Steuereingangs des Sperrschichtbauteils mit dem ersten Schwingkreisanschluss und mit dem zweiten Schwingkreisanschluss besteht.

Besonders vorteilhaft hat sich hierbei eine Schaltung erwiesen, bei der als Sperrschichtbauteil ein NMOS-Transistor vorgesehen ist.

Bevorzugt ist auch, dass zur Ansteuerung des Sperrschichtbauteils wenigstens zwei in Reihe geschaltete, überbrückbare Sperrschichtbauteile vorgesehen sind.

Bei einer vorteilhaften Ausgestaltung der Schaltung sind zur Überbrückung der in Reihe geschalteten Sperrschichtbauteile mittels zeitlich versetzter Modulationssignale angesteuerte Schalter vorgesehen.

Gemäß einer Weiterbildung der Schaltung ist vor den in Reihe geschalteten Sperrschichtbauteilen eine Polaritätswechselschaltung mit zwei parallel geschalteten Sperrschichtbauteilen mit entgegen gesetzten Durchlassrichtungen vorgesehen.

Bei einer alternativen Schaltung ist als Sperrschichtbauteil ein PMOS-Transistor vorgesehen ist.

Besonders vorteilhaft ist hierbei, wenn zur Ansteuerung des Sperrschichtbauteils eine über ein inverses Modulationssignal schaltbare Kapazität vorgesehen ist.

Weitere Vorteile ergeben sich aus der Beschreibung und den beigefügten Figuren. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert. Es zeigen, jeweils in schematischer Form:
- Fig. 1: einen Sende- und Empfangsschwingkreis mit Elementen zur Lastmo- dulation für eine erste Spannungshalbwelle
- Fig. 2: den Sende- und Empfangsschwingkreis aus Fig.1 mit Elementen zur Lastmodulation für eine zweite Spannungshalbwelle
- Fig. 3: einen weiteren Sende- und Empfangsschwingkreis mit Elementen zur Lastmodulation für eine erste Spannungshalbwelle
- Fig. 4: den Sende- und Empfangsschwingkreis aus Fig.3 mit Elementen zur Lastmodulation für eine zweite Spannungshalbwelle
- Fig. 5: den Verlauf der Schwingkreisspannungen U_{L}, U_{C1}; U_{C2}
- Fig. 6: ein gewünschtes Modulationsverhalten

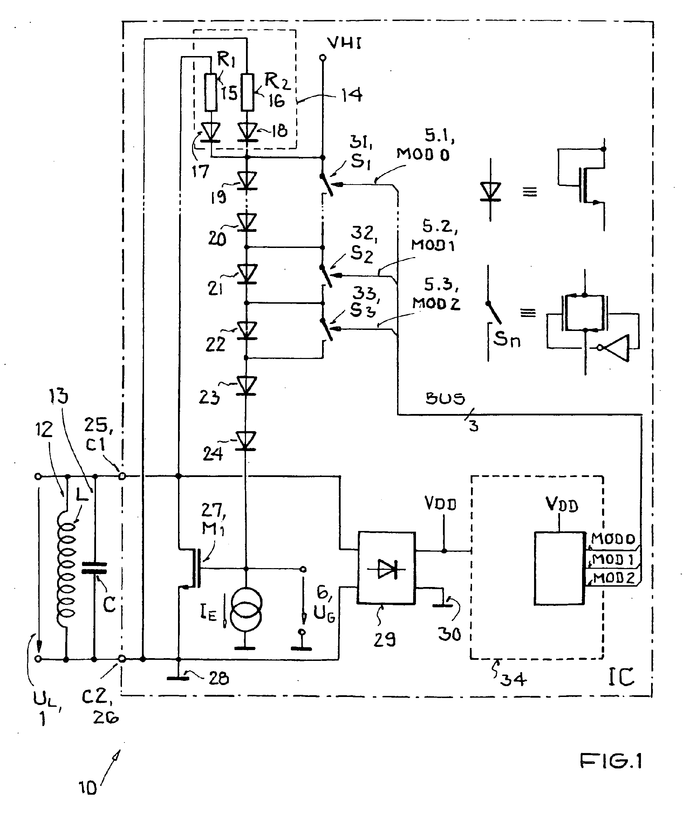

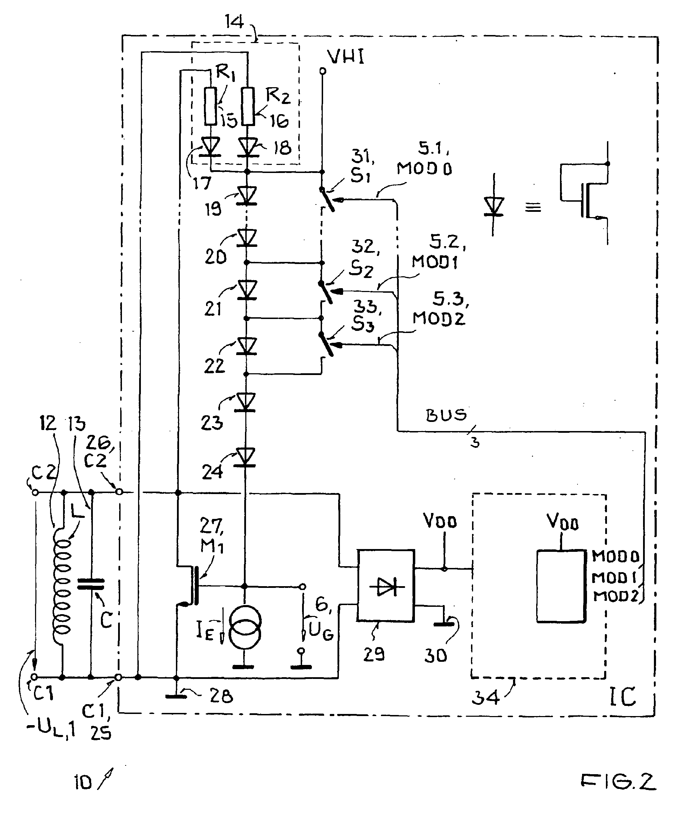

Fig. 1 und Fig. 2 zeigen einen Sende- und Empfangsschwingkreis 10 eines Empfangsteils oder tags. Parallel zum Schwingkreis 10, der eine Induktivität L 12 und eine Kapazität C 13 umfasst, liegt zwischen einem ersten Schwingkreisanschluss C₁ 25 und einem zweiten Schwingkreisanschluss C₂ 26 ein Sperrschichtbauteil 27, vorzugsweise ein NMOS-Transistor. Am Ausgang des Sperrschichtbauteils 27 liegt ein Bezugspotentialanschluss 28, der ein Massepotential für die Schaltung darstellt. Da das Sperrschichtbauteil 27 zwischen Source (Quelle) und Drain (Senke) umschalten kann, kann die Schaltung in der vorliegenden Form sowohl für eine erste als auch für eine zweite Spannungshalbwelle verwendet werden.
Ebenfalls parallel zum Schwingkreis 10 und zwischen dem ersten C₁ 25 und zweiten Schwingkreisanschluss C₂ 26, liegt eine Reihenschaltung aus Polaritätswechselschaltung 14 und Dioden 19, 20, 21, 22, 23, 24, die zur Ansteuerung des Sperrschichtbauteils 27 dienen. Hierbei können die Dioden als NMOS-Transistoren realisiert werden, die als Diode geschaltet sind. Parallel zum Sperrschichtbauteil 27 liegt weiterhin eine Gleichrichterschaltung 29 mit einem weiteren Bezugspotentialanschluss 30.
Die Polaritätswechselschaltung 14 besteht aus zwei parallelen Reihenschaltungen, die jeweils einem ohmschen Widerstand R₁ 15 bzw. R₂ 16 und eine Diode 17 bzw. 18 umfassen, wobei die Durchflussrichtung der Dioden 17, 18 unterschiedlich ist.
Die Dioden 19 bis 24 können durch Schalter S₁ 31, S₂ 32, S₃ 33 überbrückt werden, die von der Steuerschaltung 34 über kaskadierenden MOD-Signale MOD₀, MOD₁ und MOD₂ betätigt werden. Die Schalter 31, 32, 33 werden bevorzugt als Transistoren, insbesondere als MOS-Transistoren realisiert.

Das Sperrschichtbauteil 27 dient zunächst zur Begrenzung der Schwingkreisspannung U_{L} 1 zwischen den Anschlüssen 25 und 26 des Sende- und Empfangsschwingkreises 10 bei offenen Schaltern 31, 32 und 33. In diesem Zustand begrenzt das Sperrschichtbauteil 27 jeweils dann, wenn der Potentialunterschied zwischen dem Bezugspotentialanschluss 28, 30 und einem der Anschlüsse 25 oder 26 die Durchlassspannung des Sperrschichtbauteils 27 überschreitet. Dieser Wert definiert die obere Begrenzungsspannung oder erste Klemmspannung U_{KL} 2.2.
Beim Überbrücken der Dioden 19 bis 24 durch die Schalter 31, 32 und 33, wobei diese zur stufenförmigen Modulation der Spannung nacheinander und nicht zeitgleich geschlossen werden, klemmt das Sperrschichtbauteil 27 die Schwingkreisspannung U_{L} 1 auf einen niedrigeren Wert UL_{MOD} 2.1.

Durch Öffnen und Schließen der Schalter 31, 32, 33 moduliert die Steuerschaltung 34 den Wert der Schwingkreisspannung U_{L} 1 entsprechend der zu übertragenden Datenfolge. Wie beschrieben bildet sich diese Modulation des Sende- und Empfangsschwingkreises 10 des tags als Modulation der Last des Sende- und Empfangsschwingkreises des Lesegeräts unter der Voraussetzung einer transformatorischen Kopplung.

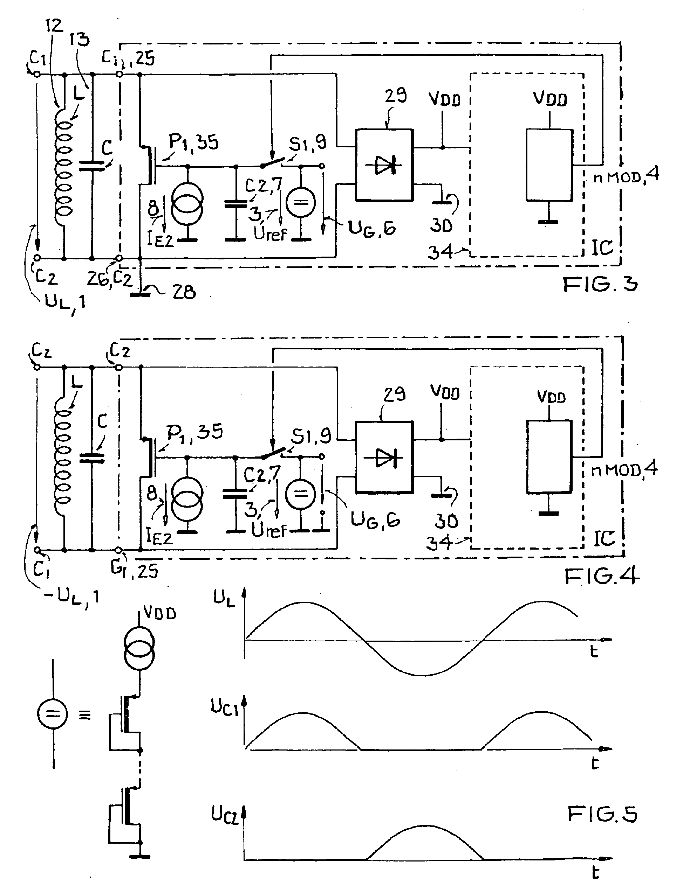

Bei den Ausführungsbeispielen gemäß der Figur 3 und der Figur 4 handelt es sich nicht um einen Teil der Erfindung, der Gegenstand des vorliegenden Anspruchsbegehrens ist. Fig. 3 und Fig. 4 zeigen einen weiteren Sende- und Empfangsschwingkreis 10 eines Empfangsteils oder tags. Hierbei zeigt Fig. 3 eine Schaltung für eine erste Spannungshalbwelle und Fig. 4 die Schaltung aus Fig. 3 für eine zweite Spannungshalbwelle. Parallel zum Schwingkreis 10, der eine Induktivität L 12 und eine Kapazität C 13 umfasst, liegt zwischen einem ersten Schwingkreisanschluss C₁ 25 und einem zweiten Schwingkrelsanschluss C₂ 26 ein Sperrschichtbauteil 35, vorzugsweise ein PMOS-Transistor. Am Ausgang des Sperrschichtbauteils 35 liegt ein Bezugspotentialanschluss 28, der ein Massepotential für die Schaltung darstellt. Zur Ansteuerung des Sperrschichtbauteils 35 dienen eine Stromquelle I_{E}, die wiederum einen Entladestrom zum Entladen einer parallel geschalteten Kapazität 7 zur Verfügung stellt, sowie eine Spannungsquelle U_{ref} 3. Dabei ist zwischen der Kapazität 7 und der Spannungsquelle U_{ref} 3 ein Schalter S₁ 9 angeordnet, der mittels eines inversen Signals nMOD 4 betätigt wird.

Das Sperrschichtbauteil 35 dient zur Begrenzung der Schwingkrelsspannung U_{L} 1 auf den Wert der oberen Klemmspannung U_{KL} 2.2 zwischen den Anschlüssen 25 und 26 des Sende- und Empfangsschwingkreises 10. Wenn der Schalter S₁ 9 geschlossen ist, liegt am Sperrschichtbauteil 35 die Spannung U_{ref} 3 an, die durch die vorgegebene Spannung U_{G} 6 am Gate begrenzt wird und somit nicht über die Schwellspannung des PMOS-Transistors hinausgehen kann. Sobald der Schalter S₁ 9 mittels des nMOD 4 Signals der Steuerschaltung 34 geöffnet wird, wird der Kondensator 7 auf den Wert U_{ref} 3aufgeladen und anschließend mittels des Entladestroms der Stromquelle I_{E2} 8 entladen. Die Folge davon ist, dass die Spannung U_{G} 6 am Gate auf null absinkt. Dadurch wird die Schwingkreisspannung U_{L} 1 auf eine zweite, kleinere Klemmspannung U_{LMOD} 2.1 begrenzt, die der Schwellspannung des PMOS-Transistors entspricht.

Fig. 5 zeigt den Verlauf der Schwingkreisspannung U_{L} 1 sowie den Verlauf der jeweiligen Spannungshalbwellen U_{C1} und U_{C2} an den beiden Schwingkreisanschlüssen C₁ 25 und C₂ 26 Die Schwingkreisspannung U_{L} 1 ergibt sich als Differenz aus den Spannungswerten an den Anschlüssen. U_{L} = U_{C1}-U_{C2}.
Wenn UL 1 positiv ist, werden bei der Schaltung gemäß Fig.1 und Fig. 3 der Schwingkreisanschluss C₂ über den Gleichrichter 29 mit einer internen Masse 30 verbunden. Im gegenteiligen Fall, wenn U_{L} 1 negativ ist, wird entsprechend der Darstellung in den Fig. 2 und Fig. 4 der Schwingkreisanschluss C₁ 26 mit der internen Masse 30 verbunden.

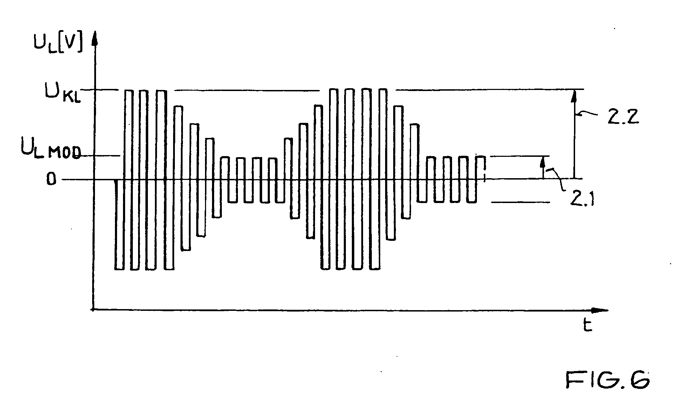

Fig. 6 zeigt einen erwünschten Verlauf der resultierenden Schwingkreisspannung UL im Empfangsschwingkreis unter dem Einfluss einer gesteuerten Lastmodulation gemäß der vorliegenden Erfindung über der Zeit t. Die großen Amplituden 2.2 stellen sich bei offenen Schaltern 31, 32, 33 gemäß Fig. 1 und Fig.2 ein und die kleinen Amplituden 2.1 stellen sich bei geschlossenen Schaltern 31, 32, 33 ein, mit denen die Dioden 19, 20, 21, 22 überbrückt werden ein.

### Bezugszeichenliste

- 1: U_{L} Schwingkreisspannung
- 2.1: UL_{MOD} untere Klemmspannung (modulierte Spannung)
- 2.2: U_{KL} obere Klemmspannung
- 3: U_{ref} Spannungsreferenz
- 4: n_{MOD} inverses Signal
- 5.1: Modulationssignal MOD₀
- 5.2: Modulationssignal MOD₁
- 5.3: Modulationssignal MOD₂
- 6: U_{G} Gatespannung
- 7: C₂ Kondensator
- 8: IE₂ Stromquelle Entladestrom
- 9: Schalter S₁
- 10: Sende - und Empfangsschwingkreis
- 11: Tag
- 12: Induktivität L
- 13: Kapazität C
- 14: Polaritätswechselschaltung
- 15: Ohmscher Widerstand R1
- 16: Ohmscher Widerstand R2
- 17: Diode bei R1
- 18: Diode bei R2
- 19: Diode
- 20: Diode
- 21: Diode
- 22: Diode
- 23: Diode
- 24: Diode
- 25: Erster Schwingkreisanschluss C₁
- 26: Zweiter Schwingkreisanschluss C₂
- 27: Sperrschichtbauteil M1
- 28: Bezugspotentialanschluss
- 29: Gleichrichterschaltung
- 30: Bezugspotentialanschluss
- 31: Schalter S₁
- 32: Schalter S₂
- 33: Schalter S₃
- 34: Steuerschaltung (Digital-Analog-Konverter)
- 35: Sperrschichtbauteil P₁

## Patentansprüche

1. Verfahren zur Spannungsbegrenzung bei einem Transponder
mit einem ersten Sende- und Empfangsschwingkreis (10), der einen ersten Schwingkreisanschluss (25) und einen zweiten Schwingkreisanschluss (26) aufweist , wobei
• ein steuerbares Sperrschichtbauelement (M1), mit einem Eingang, einen Ausgang und einem Steuereingang (27) vorgesehen ist, und
• der Eingang mit dem ersten Schwingkreisanschluss (25) verschaltet ist,
• der Ausgang mit dem zweiten Schwingkreisanschluss (26) verschaltet ist, und wobei von der Basisstation im Sende- und Empfangschwingkreis (10) zwischen dem ersten und zweiten Schwingkreisanschluss (25, 26) eine Wechselspannung induziert wird,
**dadurch gekennzeichnet, dass**
die im Sende- und Empfangsschwingkreis (10) induzierte Wechselspannung auf einen ersten Spannungswert (2.1) begrenzt wird, indem bei jeder Halbwelle der induzierten Wechselspannung durch einen Zweig einer Poleritätswechselschaltung (14) der Steuereingang (27) des steuerbaren Sperrschichtbauelementes (M1) angesteuert wird.

2. Verfahren nach Anspruch 1,
**dadurch gekennzeichnet, dass**
die induzierte Spannung mittels zwischen der Polaritätswechselschaltung (14) und dem Steuereingang (27) in Reihe liegenden Sperrschichtbauelemente (19, 20, 21, 22, 23, 24) auf einen zweiten höheren Spannungswert (2.2) begrenzt wird.

3. Verfahren nach Anspruch 2,
**dadurch gekennzeichnet, dass**
zur Lastmodulation die Spannung abwechselnd zwischen dem zweiten Spannungswert (2.2) und dem ersten Spannungswert (2.1) begrenzt wird.

4. Verfahren nach Anspruch 2 oder Anspruch 3,
**dadurch gekennzeichnet, dass**
die Änderung von dem zweiten Spannungswert (2.2) auf dem ersten Spannungswert (2.1) in wenigstens zwei Stufen erfolgt, indem wenigstens zwei Sperrschichtbauelemente (19, 20, 21, 22, 23, 24) nacheinander überbrückt werden.

5. Verfahren nach einem der Ansprüche 2 bis 4,
**dadurch gekennzeichnet, dass**
eine stufenförmige Modulation durchgeführt wird, indem von einer Steuerschaltung mittels kaskadierte MOD Signale mehrere Sperrschichtbauelemente (19, 20, 21, 22, 23, 24) nacheinander überbrückt werden.

6. Schaltung zur Spannungsbegrenzung bei einem Transponder aufweisend,
• einem Schwingkreis (19) mit
• wenigstens einer Induktivität (12) und einer Kapazität (13), die zwischen einem ersten Schwingkreisanschluss (25) und einem zweiten Schwingkreisanschluss (26) angeordnet sind,
• ein steuerbares Sperrschichtbauteil (M1) mit einem mit dem ersten Schwingkreisanschluss (25) verbundenen Eingang, einen mit dem zweiten Schwingkreisanschluss (26) verbundenen Ausgang, und einen Steuereingang (27),
**dadurch gekennzeichnet, dass**
zur Begrenzung der Spannung im Schwingkreis ein zwischen dem Steuereingang (27) und dem ersten Schwingkreisanschluss (25) liegendes Sperrschichtbauteil (18) und ein zwischen dem Steuereingang (27) und dem zweiten Schwingkreisanschluss (26) liegendes Sperrschichtbauteil (17) eine zu einander entgegengesetzte Durchlassrichtung aufweisen und eine Polaritätswechselschaltung (14) ausbilden.

7. Schaltung nach Anspruch 6,
**dadurch gekennzeichnet, dass**
die Polaritätswechselschaltung (14) aus zwei parallelen Reihenschaltungen besteht die jeweils einen ohmschen Widerstand (15, 16) und eine Diode (17,18) umfassen.

8. Schaltung nach Anspruch 7 oder Anspruch 6,
**dadurch gekennzeichnet, dass**
zwischen der Polaritätswechselschaltung (14) und dem Steuereingang (27) ein oder mehrere Sperrschichtbauteile (19, 20, 21, 22, 23, 24) vorgesehen sind.

9. Schaltung nach einem der Ansprüche 6 bis 8,
**dadurch gekennzeichnet, dass**
zur Überbrückung der mit der Polaritätswechselschaltung (14) in Reihe geschalteten Sperrschichtbauteile (19, 20, 21, 22, 23, 24) mittels zeitlich versetzter Modulationssignale (5.1, 5.2, 5.3) angesteuerte Schalter (31, 32, 33) vorgesehen sind.

10. Schaltung nach einem der Ansprüche 6 bis 9,
**dadurch gekennzeichnet, dass**
zwischen dem Steuereingang (27) und einem Bezugspotential (28) eine Stromquelle (IE) vorgesehen ist.

11. Schaltung nach einem der Ansprüche 6 bis 10,
**dadurch gekennzeichnet, dass**
als Sperrschichtbauteil (M1) ein NMOS-Transistor vorgesehen ist.

## Claims

1. Method of voltage limitation in a transponder with a first transmitting and receiving oscillator circuit (10), which comprises a first oscillator circuit terminal (25) and a second oscillator circuit terminal (26), wherein
- a controllable insulating layer component (M1) with an input, an output and a control input (27) is provided, and
- the input is connected with the first oscillator circuit terminal (25) and
- the output is connected with the second oscillator circuit terminal (26),
and wherein an alternating voltage is induced by the base station in the transmitting and receiving oscillator circuit (10) between the first and second oscillator circuit terminals (25, 26),
**characterised in that** the alternating voltage induced in the transmitting and receiving oscillator circuit (10) is limited to a first voltage value (2.1) **in that** with each half wave of the induced alternating voltage the control input (27) of the controllable insulating layer component (M1) is triggered by a branch of a polarity change circuit (14).

2. Method according to claim 1, **characterised in that** the induced voltage is limited to a second higher voltage value (2.2) by means of insulating layer components (19, 20, 21, 22, 23, 24) connected in series between the polarity change circuit (14) and the control input (27).

3. Method according to claim 2, **characterised in that** the voltage is, for load modulation, limited in alternation between the second voltage value (2.2) and the first voltage value (2.1).

4. Method according to claim 2 or claim 3, **characterised in that** the change from the second voltage value (2.2) to the first voltage value (2.1) is carried out in at least two steps in that at least two insulating layer components (19, 20, 21, 22, 23, 24) are bridged over in succession.

5. Method according to any one of claims 2 to 4, **characterised in that** the step-like modulation is carried out **in that** several insulating layer components (19, 20, 21, 22, 23, 24) are bridged over in succession by a control circuit by means of cascaded MOD signals.

6. Circuit for voltage limitation with a transponder comprising
- an oscillator circuit (19) with
- at least one inductance (12) and capacitance (13), which are arranged between a first oscillator circuit terminal (25) and a second oscillator circuit terminal (26),
- a controllable insulating layer component (M1) with an input connected with the first oscillator circuit terminal (25), an output connected with the second oscillator circuit terminal (26), and a control input (27),
**characterised in that** for limitation of the voltage in the oscillator circuit an insulating layer component (18) lying between the control input (27) and the first oscillator circuit terminal (25) and an insulating layer component (17) lying between the control input (27) and the second oscillator circuit terminal (26) have a mutually opposite pass direction and form a polarity change circuit (14).

7. Circuit according to claim 6, **characterised in that** the polarity change circuit (14) consists of two parallel series circuits which each comprise a resistive impedance (15, 16) and a diode (17, 18).

8. Circuit according to claim 7 or claim 6, **characterised in that** one or more insulating layer components (19, 20, 21, 22, 23, 24) are provided between the polarity change circuit (14) and the control input (27).

9. Circuit according to any one of claims 6 to 8, **characterised in that** switches (31, 32, 33) controlled in drive by means of modulation signals (5.1, 5.2, 5.3) displaced in time are provided for bridging over the insulating layer components (19, 20, 21, 22, 23, 24) connected in series with the polarity change circuit (14).

10. Circuit according to any one of claims 6 to 9, **characterised in that** a current source (IE) is provided between the control input (27) and a reference potential (28).

11. Circuit according to any one of the claims 6 to 10, **characterised in that** an NMOS transistor is provided as insulating layer component (M1).

## Revendications

1. Procédé destiné à limiter la tension dans un transpondeur comprenant un premier circuit oscillant émetteur-récepteur (10) présentant une première borne (25) de circuit oscillant et une deuxième borne (26) de circuit oscillant, dans lequel
. on prévoit un premier composant commandable à jonction (M1) comprenant une entrée, une sortie et une entrée de commande (27), et dans lequel
. l'entrée est connectée à la première borne (25) de circuit oscillant,
. la sortie est connectée à la deuxième borne (26) de circuit oscillant,
et dans lequel une tension alternative est induite par la station de base dans le circuit émetteur-récepteur (10) entre la première et la deuxième borne de circuit oscillant (25, 26),
**caractérisé en ce que** :
la tension alternative induite dans le circuit oscillant émetteur-récepteur (10) est limitée à une première valeur de tension (2.1), du fait qu'à chaque alternance de la tension alternative induite l'entrée de commande (27) du composant à jonction (M1) commandable est commandée par une branche de commutation d'un circuit d'alternance de polarité (14).

2. Procédé selon la revendication 1, **caractérisé en ce que** la tension induite est limitée à une deuxième valeur de tension (2.2) plus élevée au moyen de composants à jonction (19,20,21,22,23,24) montés en série entre le circuit d'alternance de polarité (14) et l'entrée de commande (27).

3. Procédé selon la revendication 2, **caractérisé en ce que** pour moduler la charge, on limite la tension alternativement entre la deuxième valeur de tension (2.2) et la première valeur de tension (2.1)

4. Procédé selon la revendication 2 ou 3, **caractérisé en ce que** le passage de la deuxième valeur de tension (2.2) à la première valeur de tension (2.1) s'effectue en au moins deux étapes, en shuntant successivement au moins deux composants à jonction (19,20,21,22,23,24).

5. Procédé selon l'une quelconque des revendications 2 à 4, **caractérisé en ce que** l'on effectue une modulation étagée, en shuntant successivement plusieurs composants à jonction (19,20,21,22,23,24) par un circuit de commande au moyen de signaux MOD en cascade.

6. Circuit destiné à limiter la tension dans un transpondeur, comprenant
. un circuit oscillant (19) présentant
. au moins une inductance (12) et un condensateur (13) montés entre une première borne (25) de circuit oscillant et une deuxième borne (26) de circuit oscillant,
. un composant à jonction (M1) commandable présentant une entrée reliée à la première borne (25) de circuit oscillant, une sortie reliée à la deuxième borne (26) de circuit oscillant, et une entrée de commande (27),
**caractérisé en ce que :**
pour limiter la tension dans le circuit oscillant, un composant à jonction (18) disposé entre l'entrée de commande (27) et la première borne (25) de circuit oscillant et un composant à jonction (17) disposé entre l'entrée de commande (27) et la deuxième borne (26) de circuit oscillant présentent un sens de conduction opposé entre eux et forment un circuit d'alternance de polarité (14).

7. Circuit selon la revendication 6, **caractérisé en ce que** le circuit d'alternance de polarité (14) est composé de deux circuits en série parallèles présentant chacun une résistance ohmique (15, 16) et une diode (17, 18).

8. Circuit selon la revendication 7 ou 6, **caractérisé en ce que** l'on prévoit un ou plusieurs composants à jonction (19,20,21,22,23,24) entre le circuit d'alternance de polarité (14) et l'entrée de commande (27).

9. Circuit selon l'une quelconque des revendications 6 à 8, **caractérisé en ce que** l'on prévoit des interrupteurs (31,32,33) commandés par des signaux de modulation (5.1, 5.2, 5.3) décalés dans le temps pour shunter les composants à jonction (19,20,21,22,23,24) montés en série avec le circuit d'alternance de polarité (14).

10. Circuit selon l'une quelconque des revendications 6 à 9, **caractérisé en ce que** l'on prévoit une source de courant (IE) entre l'entrée de commande (27) et le potentiel de référence.

11. Circuit selon l'une quelconque des revendications 6 à 10, **caractérisé en ce que** l'on prévoit un transistor NMOS comme composant à jonction (M1).
